# EUROPÄISCHE PATENTSCHRIFT

(11) **EP 0 570 815 B1**
(45) Veröffentlichungstag und Bekanntmachung des Hinweises auf die Patenterteilung: **02.09.1998**
(21) Anmeldenummer: 93107666.5
(22) Anmeldetag: 11.05.1993
(51) Int. Cl.: G03F 3/10, G03F 7/09

(54) **Verfahren zur Herstellung eines Mehrfarbenbilds und lichtempfindliches Material zur Durchführung dieses Verfahrens**
Method for producing a multicoloured image and photosensitive material for implementing this method
Procédé pour fabriquer une image multicolore et matériel photosensible pour la mise en oeuvre de ce procédé

(30) Priorität: 18.05.1992 DE 4216359
(43) Veröffentlichungstag der Anmeldung: 24.11.1993
(73) Patentinhaber: Agfa-Gevaert AG, 51373 Leverkusen (DE)
(72) Erfinder: März, Karin, Dr., W-6500 Mainz (DE); Gramm, Ine, W-6200 Wiesbaden (DE); Hilger, Manfred, W-5503 Konz (DE); Mohr, Dieter, Dr., W-6501 Budenheim (DE); Platzer, Stephan J.W., Dr., W-6228 Eltville-Erbach (DE)

(56) Entgegenhaltungen:
- EP-A- 0 357 324
- EP-A- 0 525 624

## Beschreibung

Die Erfindung betrifft ein lichtempfindliches, insbesondere photopolymerisierbares Material für die Herstellung von Farbprüffolien für den Mehrfarbendruck. Sie betrifft ferner ein Farbprüfverfahren, bei dem auf einem Bildempfangsmaterial ein Mehrfarbenbild aus mehreren Teilfarbenbildern im Register erzeugt wird. Die Teilfarbenbilder werden durch Laminieren einer in einer Grundfarbe eingefärbten photopolymerisierbaren Schicht auf das Bildempfangsmaterial, Belichten unter dem zugehörigen Farbauszug, Entwickeln des Bilds durch Abziehen der Trägerfolie der photopolymerisierbaren Schicht zusammen mit den Nichtbildstellen und Wiederholen der gleichen Schritte mit einer photopolymerisierbaren Schicht einer anderen Grundfarbe hergestellt.

Ein derartiges Farbprüfverfahren und ein hierfür vorgesehenes Material sind aus der US-A 4 895 787 bekannt. Dieses Material besteht aus einer transparenten Trägerfolie, deren Oberfläche vorzugsweise haftvermittelnd vorbehandelt worden ist, einer photopolymerisierbaren Schicht, die einen Farbstoff oder ein Farbpigment in einer Grundfarbe des Mehrfarbendrucks enthält und einer durch Erwärmen aktivierbaren Haftschicht auf der photopolymerisierbaren Schicht. Das Material wird nach Laminieren auf ein Bildempfangsmaterial und Belichten durch die Trägerfolie durch Auseinanderziehen ("peel apart") von Trägerfolie und Bildempfangsmaterial entwickelt, wobei die belichteten Bereiche der lichtempfindlichen Farbschicht an der Trägerfolie, die unbelichteten Bereiche zusammen mit der gesamten Haftschicht auf dem Bildempfangsmaterial verbleiben. Das Verfahren arbeitet also positiv, d. h. auf dem Bildempfangsmaterial entsteht ein positives Abbild der Vorlage.

Dieses Verarbeitungsverfahren hat den großen Vorteil, daß es zur Entwicklung keine alkalischen oder sauren Lösungen und keine organischen Lösemittel erfordert, deren Entsorgung damit entfällt. Ein Nachteil dieses Verfahrens ist es, daß sich die Adhäsions- und damit Abziehkräfte in den ersten Wochen nach der Herstellung der Folien als Folge von Diffusions- und Konditionierungsvorgängen erhöhen. Damit verschlechtern sich die für eine saubere und problemlose Bildentwicklung durch Auseinanderziehen erforderlichen Eigenschaften, insbesondere die für dieses Verfahren notwendige niedrige Haftkraft zwischen lichtempfindlicher Farbschicht und Haftschicht.

In der älteren Patentanmeldung P 42 04 950.4 (Hoe 92/K005) wurde bereits vorgeschlagen, der Haftschicht ein farbloses Pigment einer Teilchengröße zuzusetzen, die 1 bis 100, bevorzugt 20 bis 70 % der Schichtdicke entspricht. Durch diesen Zusatz wird die Oberflächenklebrigkeit herabgesetzt.

In der in der älteren Patentanmeldung beschriebenen Haftschicht ist ferner ein Zusatz von etwa 1,4 Gew.-% Natriumsulfit enthalten. Dieser Zusatz ist erforderlich, wenn das polymere Bindemittel der Haftschicht, ein Vinylacetat/Crotonsäure-Copolymeres, bereits in wäßriger Lösung bezogen und längere Zeit, d.h. einige Wochen oder länger, in dieser Lösung gelagert werden soll. Solche wäßrigen Lösungen neigen zu einer bräunlichen Verfärbung, die durch den Zusatz des Reduktionsmittels Natriumsulfit verhindert werden kann. Es wird vermutet, daß die Verfärbung auf die Autoxydation von im Polymeren enthaltener monomerer Crotonsäure zurückzuführen ist. Dieser Zusatz ist nicht erforderlich, wenn das Polymere als Festsubstanz gelagert und kurz vor der Beschichtung in Wasser aufgelöst wird.

Die genannte zu starke Haftung der Haftschicht an der Farbschicht bewirkt bei den zur Herstellung von Farbprüfbildern nach dem peel-apart-Verfahren eingesetzten Materialien eine Reihe von weiteren verbesserungsbedürftigen Eigenschaften. Sie ergeben häufig Bilder mit einer unerwünschten Hintergrundfärbung und mit ungleichmäßiger, rauher Oberfläche der Hintergrund- bzw. Nichtbildstellen. Die Belichtungszeiten sind relativ hoch, da die belichteten Stellen stark an der Haftschicht haften. Deshalb muß der bilddifferenzierende Photopolymerisationsgrad größre sein als bei einer geringen Haftung zwischen Haft- und Farbschicht.

Aufgabe der Erfindung war es daher, ein lichtempfindliches Material und ein Farbprüfverfahren der eingangs beschriebenen Gattung zur Verfügung zu stellen, bei dem die Haftkraft zwischen der belichteten photopolymerisierbaren Farbschicht und der Haftschicht herabgesetzt ist, so daß es eine geringere Bildbelichtung erfordert, eine geringere Hintergrundverfärbung und einen erhöhten Oberflächenglanz des Bildhintergrundes ergibt.

Erfindungsgemäß wird ein lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
   B1) ein polymeres Bindemittel,
   B2) eine radikalisch polymerisierbare Verbindung,
   B3) eine Verbindung, die unter Einwirkung von aktinischem Licht die Polymerisation von (B2) einzuleiten vermag, und
   B4) einen Farbstoff oder ein Farbpigment in einer Grundfarbe des Mehrfarbendrucks enthält, und
C) einer thermoplastischen Haftschicht auf der lichtempfindlichen Schicht vorgeschlagen.

Das erfindungsgemäße Material ist dadurch gekennzeichnet, daß die Haftschicht C mindestens 1,5 Gew.-% eines wasserlöslichen farblosen niedermolekularen Salzes enthält, dessen wäßrige Lösung nicht stark sauer reagiert, d.h. einen pH-Wert oberhalb etwa 3 aufweist.

Erfindungsgemäß wird ferner ein Verfahren zur Herstellung eines Mehrfarbenbildes vorgeschlagen, das dadurch gekennzeichnet ist, daß man ein lichtempfindliches Material der in Anspruch 1 angegebenen Zusammensetzung mit der Haftschicht unter Druck auf ein Bildempfangsmaterial laminiert, durch die Trägerfolie hindurch mit einem Farbauszug bildmäßig belichtet, die Trägerfolie zusammen mit den Nichtbildstellen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

Gemäß einer anderen Ausführungsform der Erfindung wird ein Verfahren zur Herstellung eines Mehrfarbenbildes vorgeschlagen, das darin besteht, daß man eine Haftschicht der in Anspruch 1 angegebenen Zusammensetzung auf ein Bildempfangsmaterial laminiert, ein lichtempfindliches Material aus einer transparenten flexiblen Trägerfolie und einer photopolymerisierbaren Schicht der in Anspruch 1 angegebenen Zusammensetzung mit der photopolymerisierbaren Schicht auf die Haftschicht laminiert, die photopolymerisierbare Schicht durch die Trägerfolie hindurch mit einem Farbauszug bildmäßig belichtet, die Trägerfolie zusammen mit den Nichtbildstellen von dem Bildempfangsmaterial abzieht und die Schritte
- Laminieren einer Haftschicht
- Laminieren eines lichtempfindlichen Materials
- Belichten und
- Abziehen
mit mindestens einem weiteren Farbauszug wiederholt, wobei das Belichten im Register mit dem ersten auf dem Bildempfangsmaterial erzeugten Teilfarbenbild erfolgt.

Erfindungsgemäß wird schließlich noch die Verwendung eines wasserlöslichen farblosen niedermolekularen Salzes als Zusatz zu einer thermoplastischen Haftschicht in Verbindung mit einer photopolymerisierbaren Schicht der in Anspruch 1 angegebenen Zusammensetzung zur Verminderung der Haftkraft zwischen thermoplastischer Haftschicht und photopolymerisierbarer Schicht vorgeschlagen.

Der Zusatz eines Salzes zur Haftschicht gemäß der vorliegenden Erfindung bewirkt bereits in kleiner Menge eine deutliche Verminderung der Haftung und damit der zur Bildentwicklung erforderlichen Abziehkraft an den belichteten Stellen. An den unbelichteten Stellen bleibt nach Zusatz des Salzes die Haftung zwischen Haftschicht und photopolymerisierbarer Farbschicht größer als zwischen der Farbschicht und der Trägerfolie. In jedem Einzelfall kann die zur Erzielung der gewünschten Haftungsverminderung erforderliche Menge an Salz durch einfache Versuche ermittelt werden. Bei Erhöhung der Salzkonzentration wird zwar die Haftung weiter herabgesetzt sowie die Lichtempfindlichkeit, der Glanz und die Klarheit des Bildhintergrundes weiter verbessert; zugleich aber der Tonwertumfang der Kopie herabgesetzt, d.h. die Rasterspitzpunkte werden ebenso wenig wie die Rastertiefen abgebildet. In jedem Fall ist also eine optimale Ausgewogenheit zwischen Haftung, Lichtempfindlichkeit und Hintergrundschleier einerseits und Tonwertumfang andererseits herzustellen. Im allgemeinen ist bereits bei etwa 0,2 % Salzzusatz eine deutlich erkennbare Verbesserung zu erreichen. Ab 1,5 % ist diese Verbesserung signifikant. Die Obergrenze wird, wie vorstehend ausgeführt, durch die Herabsetzung des Tonwertumfangs bestimmt. Konzentrationen oberhalb 10 % führen im allgemeinen nicht mehr zu vorteilhaften Ergebnissen. Bevorzugt wird ein Konzentrationsbereich von etwa 2 bis 5 %.

Das Salz kann ein anorganisches oder organisches Salz sein. Die Natur des Salzes ist für das Ergebnis zumeist nicht entscheidend. Im allgemeinen werden anorganische Salze, insbesondere Alkali- oder Erdalkalisalze sowie Ammoniumsalze, mit Vorteil eingesetzt. Es können auch organische Kationen, insbesondere quaternäre Ammoniumionen enthalten sein. Von diesen werden kationische oberflächenaktive Salze besonders bevorzugt. Als Anionen werden im allgemeinen solche von Mineralsäuren, wie Schwefelsäure, schweflige Säure, Phosphorsäure, Halogenwasserstoffsäuren, Salpetersäure und dgl. eingesetzt. Auch können Salze einfacher niedermolekularer organischer Säuren zugesetzt werden. Wesentlich ist, daß die Lösung des Salzes nicht stark sauer ist und daß das Anion und das Kation nicht polymer sind.
Beispiele für geeignete Salze sind Natriumchlorid, Natriumsulfit, Natriumsulfat, Natriumfluorid, -bromid, -jodid sowie die entsprechenden Kalium-, Ammonium-, Lithium-, Magnesium- oder Calciumsalze. Als organische Salze sind z.B. Natrium-, Kalium-, Ammonium- oder Lithiumacetat, -propionat, -butyrat, -tartrat, -crotonat sowie Zwitterionen von Aminosäuren geeignet. Besonders bevorzugt werden als organische Salze die kationischen Tenside. Auch anionische Tenside, z.B. Salze von langkettigen aliphatischen oder aliphatisch-aromatischen Carbon- oder Sulfonsäuren, können eingesetzt werden. Die Salze müssen in der Beschichtungslösung für die Haftschicht löslich sein. Da diese im allgemeinen eine wäßrige Lösung ist, sollten die Salze wasserlöslich sein.

Die thermoplastische Haftschicht kann entweder aus einem Lösemittel oder Lösemittelgemisch, das die photopolymerisierbare Schicht nicht anlöst, direkt auf diese aufgebracht und getrocknet werden. Sie kann auch zuerst auf eine temporäre Trägerfolie aufgebracht und von dort durch Laminieren und Abziehen der Trägerfolie auf die photopolymerisierbare Farbschicht oder auf das Bildempfangsmaterial übertragen werden. Gemäß einer anderen Ausführungsform kann die Haftschicht durch Beschichten des Bildempfangsmaterials aus einem Lösemittel und Trocknen erhalten werden. Auf die so erhaltene Haftschicht wird dann die photopolymerisierbare Schicht durch Laminieren übertragen. Das direkte Aufbringen aus Lösemitteln auf die photopolymerisierbare Schicht wird bevorzugt. Ein geeignetes Lösemittel, das die Farbschicht nicht anlöst, ist Wasser. Viele Polymere können aus wäßriger Dispersion aufgebracht werden; das Aufbringen aus Lösung wird aber bevorzugt. Hierfür eignen sich z.B. Salze von Polymerem mit Säuregruppen, z.B. Carboxylgruppen. Ein bevorzugtes Beispiel ist eine wäßrig-alkalische Lösung eines Vinylacetat/Crotonsäure-Copolymeren (Mowilith ^{(R)}Ct 5). Andere geeignete Polymere sind Polyvinylacetat- oder Polyacrylatdispersionen. Das Polymere sollte eine Erweichungstemperatur im Bereich von 40 bis 200, vorzugsweise von 60 bis 130 °C haben. Die Haftschicht kann außer dem thermoplastischen Polymeren und dem Salz noch Weichmacher, Haftvermittler, Restlöser, Oberflächenausgleichsmittel, Gleitmittel, Antistatika, inerte Füllstoffe, optische Aufheller und/oder UV-Absorber enthalten. Ihr Schichtgewicht im trockenen Zustand beträgt normalerweise 2 bis 30, vorzugsweise 4 bis 15 g/m2. Übliche Haftschichten sind in der US-A 4 895 787 beschrieben. Die Haftschicht kann zur Steigerung ihrer Kohäsionskraft mit Vorteil auch Polyvinylalkylether als Haftvermittler enthalten, wie es in der älteren Patentanmeldung P 41 25 723.5 beschrieben ist. Die photopolymerisierbare Schicht des erfindungsgemäßen Materials enthält als wesentliche Bestandteile ein polymeres Bindemittel, eine radikalisch polymerisierbare Verbindung, eine Verbindung, die bei Einwirkung von aktinischem Licht freie Radikale bildet und damit die Polymerisation der polymerisierbaren Verbindung einleitet, und einen Farbstoff oder ein Farbpigment in einer Grundfarbe des Mehrfarbendrucks. Beispiele für photopolymerisierbare Schichten dieser Zusammensetzung sind in der US-A 4 895 787 beschrieben, auf die hier Bezug genommen werden soll.

Das polymere Bindemittel soll der Schicht Homogenität und Festigkeit verleihen. Geeignete Bindemittel sind Styrol/Maleinsäureanhydrid- und Styrol/Maleinsäurehalbester-Copolymere, Acrylesterpolymere und -copolymere, Polyamide, Polyvinylpyrrolidone, Cellulosederivate, wie Celluloseester und -ether, Phenolharze, Polyvinylester, Polyvinylacetale, z. B. Polyvinylbutyral, -propional oder -formal. Der Mengenanteil des Bindemittels beträgt im allgemeinen 15 bis 70, vorzugsweise 20 bis 50 Gew.-%, bezogen auf das Gewicht der festen Schicht.

Die polymerisierbare Verbindung enthält mindestens eine, bevorzugt mindestens zwei endständige radikalisch polymerisierbare Doppelbindungen und ist bei Temperaturen unterhalb 100 °C und bei Normaldruck nicht gasförmig. Bevorzugt werden Ester und Amide der Acryl- und Methacrylsäure. Besonders die Ester mit mehrwertigen Alkoholen werden mit Vorteil eingesetzt. Beispiele sind Di-, Tri-, Tetra- und Polyethylenglykoldi(meth)acrylat, die Di(meth)acrylate von Oligo- und Polypropylenglykolen, 1,4-Butandioldi(meth)acrylat, Trimethylolpropan- und Trimethylolethandi- und -tri(meth)acrylat, Pentaerythrittriund -tetraacrylat oder -methacylat, Dipentaerythrittetra-, -penta- und -hexa(meth)acrylat. Der Mengenanteil an polymerisierbarer Verbindung beträgt im allgemeinen 15 bis 70, vorzugsweise 20 bis 60 Gew.-%.

Als Photoinitiatoren sind im wesentlichen alle für diesen Zweck bekannten Verbindungen oder Verbindungskombinationen geeignet. Beispiele sind Benzoinether, Benzilketale, Mehrkernchinone, Benzophenonderivate, Triarylimidazolyldimere, lichtempfindliche Trihalogenmethylverbindungen, z. B. Trichlormethyl-s-triazine. Besonders bevorzugt werden 2-Aryl-4,6-bis-trichlormethyl-s-triazine. Die Menge an Photoinitiator bzw. an Photoinitiatorkombination liegt im allgemeinen zwischen 1 und 25, vorzugsweise zwischen 5 und 15 Gew.-%.

Die Farbstoffe bzw. Farbpigmente werden so ausgewählt, daß sie den Grundfarben des Mehrfarbendrucks, Cyan (Blaugrün); Magenta (Purpur); Gelb und Schwarz, entsprechen. Pigmente werden im allgemeinen bevorzugt. Beispiele sind Permanentgelb G (C.I. 21 095), Permanent-gelb GR (C.I. 21 100), Permanentgelb DHG (C.I. 21 090), Permanentrubin L3B (C.I. 15 850 : 1), Permanent Pink F3B (C.I. 12 433), Hostaperm Pink E (C.I. 73 915), Hostaperm Rotviolett ER (C.I. 46 500), Permanentcarmin FBB (C.I. 12 485), Hostapermblau B2G (C.I. 74 160), Hostapermblau A2R (C.I. 74 160) und Printex 25 (Ruß).

Die Pigmente können ggf. zur Erzielung des gewünschten Farbtons abgemischt werden. Die anorganischen oder organischen Pigmente werden im allgemeinen zusammen mit einem Teil des Bindemittels in einem geeigneten Lösemittel dispergiert oder angeteigt. Die mittlere Partikelgröße liegt i. a. unterhalb 1 µm.

Der Mengenanteil des Farbstoffs oder Pigments beträgt im allgemeinen 8 bis 40, vorzugsweise 12 bis 30 Gew.-%.

Die photopolymerisierbare Schicht kann ggf. weitere Bestandteile, wie Wasserstoffdonatoren, Sensibilisatoren, Polymerisationsinhibitoren, Weichmacher, Restlöser, Tenside, Oberflächenausgleichsmittel, Gleitmittel, Haftvermittler, z.B. die in der oben erwähnten älteren Anmeldung beschriebenen Polyvinylalkylether, Antistatika, inerte Füllstoffe, optische Aufheller und/oder UV-Absorber, enthalten. Sie hat im allgemeinen ein Schichtgewicht von 0,2 bis 5, bevorzugt 0,3 bis 3 g/m².

Nach dem Trocknen der photopolymerisierbaren Schicht wird auf diese die wärmeaktivierbare thermoplastische Haftschicht aufgebracht.

Als Trägerfolien werden transparente, flexible, dimensionsstabile Folien aus Kunststoffen, z. B. Polyestern, Polycarbonaten usw., eingesetzt. Besonders bevorzugt werden Polyesterfolien, insbesondere biaxial verstreckte und wärmefixierte Folien, z. B. aus Polyethylenterephthalat.

Diese sollten bei den erforderlichen Laminiertemperaturen, d. h. von etwa 60 bis 150 °C maßhaltig bleiben. Ihre Dicke beträgt im allgemeinen 10 bis 200, vorzugsweise 25 bis 80 µm. Die Trägerfolie wird vorteilhaft ein- oder beidseitig haftvermittelnd vorbehandelt und kann eine glatte oder eine rauhe bzw. matte, vorzugsweise eine glatte Oberfläche haben.

Zur Durchführung des erfindungsgemäßen Verfahrens wird das oben beschriebene lichtempfindliche Material mit der Haftschicht auf ein Bildempfangsmaterial laminiert. Dieses kann aus Kunststoff, kunststoffbeschichtetem Spezialpapier oder aus normalem Bedruckpapier bestehen. Andere weiße und ggf. auch nicht-weiße Empfangsmaterialien können ebenfalls verwendet werden. Ein unter den Laminierbedingungen maßhaltiges Bedruckpapier wird gewöhnlich bevorzugt, da damit ein dem späteren Druck weitgehend nahekommender visueller Eindruck erzielt wird. Das Laminieren erfolgt zweckmäßig in einem hierfür vorgesehenen Gerät unter Druck und bei erhöhter Temperatur. Die Laminiertemperatur liegt gewöhnlich im Bereich von 60 bis 130, bevorzugt zwischen 70 und 100 °C. Nach dem Laminieren wird die photopolymerisierbare Schicht durch die Trägerfolie hindurch bildmäßig, i. a. im Kontakt unter einem Positiv-Farbauszug in bekannter Weise belichtet. Nach dem Belichten wird die Trägerfolie mit der Hand oder in einer geeigneten Vorrichtung abgezogen. Der Abziehwinkel sollte mindestens 90° betragen, ein Winkel von 180° wird besonders bevorzugt. Dabei werden die belichteten Bereiche der photopolymerisierbaren Schicht mit der Trägerfolie entfernt, während die unbelichteten zusammen mit der gesamten Haftschicht auf dem Bildempfangsmaterial verbleiben. Auf diese Weise wird ein positives Teilfarbenbild erhalten. Jede weitere Farbprüffolie wird in der beschriebenen Weise auf das vorangehende Teilfarbenbild laminiert, dort im Register belichtet und durch Abziehen der Trägerfolie entwickelt. So wird aus den Teilfarbenbildern der Farben Cyan (Blaugrün), Magenta (Purpur), Gelb und Schwarz ein vollständiges Mehrfarbenbild erzeugt, das dem späteren 4-Farben-Druckbild entspricht. Bei Bedarf können selbstverständlich auch Farbprüffolien in Sonderfarben eingesetzt werden.

Entscheidend für die Qualität der Ergebnisse des beschriebenen Farbprüfverfahrens ist die sorgfältige Abstimmung der Adhäsions- und Kohäsionskräfte, die zwischen der photopolymerisierbaren Schicht und der thermoplastischen Haftschicht bzw. innerhalb dieser Schichten wirken. Das erfindungsgemäße Material zeichnet sich dadurch aus, daß bei hoher Kohäsionskraft der Haftschicht die Haftkräfte zwischen der photopolymerisierbaren Farbschicht und der Haftschicht nach dem Belichten gering sind. Das bedeutet, daß für die Entwicklung nur eine niedrige Abziehkraft erforderlich ist, die maximal 3 - 4 mal so groß ist wie die Abziehkraft, die für das unbelichtete Laminat erforderlich ist. Das erfindungsgemäße Material und Verfahren unterscheidet sich durch diese niedrigen Abziehkräfte ganz wesentlich von anderen im Handel befindlichen Materialien und Systemen, die mit etwa der 10-fachen Abziehkraft in den belichteten Bereichen arbeiten und darüberhinaus möglichst große Unterschiede zwischen den Haftkräften anstreben, die zwischen der Haftschicht und der belichteten Farbschicht einerseits und der Haftschicht und der unbelichteten Farbschicht andererseits wirken.

Die bei dem erfindungsgemäßem Verfahren erforderlichen niedrigen Abziehkräfte sind aber für die damit erzielbare Bildqualität entscheidend. Niedrige Abziehkräfte ermöglichen einen manuellen, gleichmäßigen Abziehvorgang zur Bildentwicklung auch bei sehr großen Formaten (70x100cm). Dadurch werden maschinelle Abziehvorrichtungen überflüssig. Die Rasterpunktkonturen bleiben sauber erhalten, die Belichtungszeiten, die für den optimalen Tonwertumfang von 2 - 98 % erforderlich sind, verkürzen sich. Da sich die belichtete Farbschicht sehr leicht von der Haftschicht trennen läßt, zeigt der Bildhintergrund (= Haftschichtoberfläche ohne Farbschicht) einen starken, mit den Bildstellen vergleichbaren Glanz, der nach mikroskopischen Untersuchungen auf eine vollständig geschlossene Schichtoberfläche zurückzuführen ist. Hohe Abziehkräfte führen dagegen zu einem Zerreißen der Rasterpunktkonturen und der Haftschichtoberfläche während des Entwicklungsvorganges. Die Bildstellen erscheinen glänzend vor einem matten Bildhintergrund, was sich störend auf den Gesamtbildeindruck auswirkt. Ein weiterer Vorteil ist ein bei niedrigen Abziehkräften reduzierter Hintergrundschleier, da kaum Farbschichtreste auf der Haftschichtoberfläche zurückbleiben.

In den folgenden Beispielen wird in der Regel zur Herstellung der Haftschicht eine wäßrige Polymerlösung eingesetzt, die wie eingangs erläutert, etwa 1,4 % Natriumsulfit zur Stabilisierung enthält. Die Beispiele 1 und 7 zeigen, daß mit diesem Zusatz gegenüber einer Schicht, die kein Natriumsulfit enthält (Vergleichsbeispiel), bereits eine erhebliche Verbesserung erzielt wird. In den Beispielen wird die zur Trennung von Trägerfolie und Bildempfangsblatt erforderliche Abziehkraft angegeben. Sie wird bei einer Abziehgeschwindigkeit von 1 m/Minute in einem Winkel von 180° gemessen. Die angegebene Belichtungszeit ist diejenige, bei der die optimale Bildauflösung, d.h. der größte Tonwertumfang bei der Entwicklung, erzielt wird. Die Belichtungszeit wird ebenso wie die Abziehkraft in Relativwerten angegeben. Dabei wird jeweils der für die gleiche Farbe mit einer Haftschicht, die 1,4 % Natriumsulfit enthält, erhaltene Wert mit 100 angesetzt. Eine Angabe von Absolutwerten ist nicht sinnvoll, da diese von so zahlreichen Einzelparametern der Versuchsführung abhängen, daß sie keine Aussagekraft haben.
Der Oberflächenglanz des Bildhintergrundes wird mit einem Reflektometer (RL3, Dr.B.Lange, Berlin, Standard A) gemessen. Das Maß für den Oberflächenglanz ist die reflektierte Lichtintensität. Diese wird jeweils unter Winkeln von 20, 60 und 85° zur Bildebene gemessen. Je höher die Werte sind, desto intensiver ist der Glanz.
Als Maß für die Hintergrundfärbung bzw. den Farbschleier wird die optische Dichte in den Nichtbildstellen mit einem Densitometer ermittelt. Um die gemessenen Werte zu verstärken, wird dazu eine Farbfolie auf das Empfangsblatt laminiert und über die zuvor ermittelte optimale Belichtungszeit, d.h. die Zeit, nach der der größte Tonwertumfang erreicht wird, belichtet. Nach dem Abziehen der Trägerfolie wird der Vorgang noch dreimal mit einer gleichen Farbfolie unter gleichen Bedingungen wiederholt. Als Bezug für die Messung der Hintergrundfärbung dient die optische Dichte des Bildempfangsblattes vor dem ersten Laminieren.
Der Tonwertumfang bezeichnet die in der entwickelten Kopie wiedergegebenen Rasterpunkte im 60er Raster, d.h. einem Raster von 60 Linien je cm linear. Ein Rasterpunkt von 10 % bedeutet, daß bei gleichmäßiger Bedeckung mit Punkten dieser Größe 10 % der Oberfläche mit Punkten bedeckt sind.

Die Erfindung wird durch die folgenden Beispiele erläutert. Dabei sind die Mengen in Gewichtsteilen (Gt) angegeben. Prozentzahlen und Mengenverhältnisse sind, wenn nichts anderes angegeben ist, auf Gewichtseinheiten bezogen.

### Beispiel 1

Die Beschichtungslösungen für die photopolymerisierbaren Schichten bestehen aus folgenden Komponenten in Gewichtsteilen. Die Farbpigmente werden zur besseren Anpassung an handelsübliche Druckfarben gemischt.

| | Cyan | Magenta | Gelb | Schwarz |
|---|---|---|---|---|
| Dipentaerythritpentaacrylat | 39,0 | 35,5 | 38,2 | 36,1 |
| 2-Biphenyl-4-yl-4,6-bis-trichlormethyl-s-triazin | 9,8 | 7,8 | 9,5 | 9,6 |
| Polyvinylformal (Formvar^{(R)}12/85) | 31,3 | 36,5 | 35,4 | 28,0 |
| Hostaperm^{(R)} Blau B2G (C.I. 74 160) | 19,0 | - | - | - |
| Permanentcarmin FBB (C.I. 12 485) | - | 18,5 | - | - |
| Permanentgelb GR (C.I. 21 100) | - | 0,7 | 16,4 | - |
| Ruß (Printex^{(R)} 25) | 0,4 | 0,5 | - | 24,8 |
| Silikonöl (Edaplan ^{(R)} LA 411) | 0,5 | 0,5 | 0,5 | 0,6 |
| Tetrahydrofuran | 1000,0 | 1000,0 | 1000,0 | 1000,0 |
| 1-Methoxy-2-propanol | 680,0 | 680,0 | 680,0 | 680,0 |
| gamma-Butyrolacton | 190,0 | 190,0 | 190,0 | 190,0 |

Die Pigmente werden mit einem Teil des Bindemittels und des Butyrolactons dispergiert. Die mittlere Teilchengröße liegt unterhalb 200 nm. Die Dispersion und die übrigen Bestandteile werden gemischt und auf eine 50 µm dicke biaxial verstreckte und thermofixierte Polyethylenterephthalatfolie, die auf beiden Seiten zur Haftverbesserung vorbehandelt worden ist (Melinex^{(R)} 505), aufgetragen. Die Schichten werden bei 70 °C getrocknet. Die Schichtgewichte liegen zwischen 0,6 und 0,8 g/m².

Die Haftschichtlösung setzt sich wie folgt zusammen:

| | |
|---|---|
| Vinylacetat/Crotonsäure-Copolymeres 95:5 Mowilith^{(R)} Ct5 | 96,6 Gt |
| Polyvinylmethylether (Lutonal ^{(R)} M 40) | 1,9 Gt |
| Natriumsulfit | 1,4 Gt |
| Wasser | 520,0 Gt |
| Ethanol | 43,0 Gt |
| Ammoniakwasser, 25 %-ig | 8,5 Gt |

Die Lösung wird auf die trockenen photopolymerisierbaren Schichten aufgetragen und getrocknet. Das Schichtgewicht der trockenen Haftschicht beträgt 6,5 g/m².

Eine der so hergestellten Folien, z. B. die Cyan-Farbfolie, wird bei 85 °C auf kunststoffbeschichtetes Spezialpapier laminiert und unter dem Cyan-Farbauszugsfilm belichtet. Die Trägerfolie wird kontinuierlich in einem Winkel von 180° von Hand abgezogen. Auf dem Papier verbleiben die Haftschicht und das positive Cyan-Bild, auf das nacheinander die weiteren Farbfolien laminiert werden.

Der Tonwertumfang erreicht in einem Raster von 60 Linien/cm für alle Farben 2 - 98 % , d.h. es werden die Rasterpunkte, deren Größe der angegebenen Flächendeckung in % entspricht, noch wiedergegeben.

### Beispiel 2

Die Zusammensetzung der photopolymerisierbaren Farbschichten entspricht den Angaben von Beispiel 1; es wird aber der Natriumsulfitgehalt in der Haftschicht wie folgt erhöht:

| Beispiel | Gehalt an Na₂SO₃ |
|---|---|
| 2a | 3,4 Gt |
| 2b | 4,4 Gt |
| 2c | 6,4 Gt |

Das Salz wird vor dem Zusetzen in einem Teil des Wassers gelöst, das Bestandteil der Haftschichtlösung ist. Die fertigen Haftschichtlösungen werden jeweils auf die trockenen Farbschichten aufgetragen. Nach dem Trocknen beträgt das Schichtgewicht der Haftschichten 6,5 g/m². Die Folien werden in der in Beispiel 1 beschriebenen Weise zu Einzel- bzw. Mehrfarbenbildern verarbeitet. Während sich die Abziehkräfte im unbelichteten Zustand gegenüber Beispiel 1 nicht verändern, werden im belichteten Zustand je nach Farbe und Konzentration des Salzzusatzes Abziehkräfte gemessen, die um bis zu 76 % im Vergleich zum Beispiel 1 reduziert sind. Der Oberflächenglanz ist in allen Fällen höher, die Belichtungszeiten sind wesentlich kürzer. Der Hintergrundschleier wird bei Magenta deutlich, bei Gelb etwas reduziert. Im Fall des Beispiels 2a beträgt für alle vier Farben der Tonwertumfang 2 - 98 %. Eine weitere Erhöhung des Salzzusatzes führt zu einer Verkleinerung des Tonwertumfanges und damit zu einer Verschlechterung der Auflösung. Diese Beispiele zeigen, daß die Abziehkraft nicht beliebig gesenkt werden kann. Die Tabelle I zeigt die Werte im einzelnen.

### Beispiel 3

Zusätzlich zu den 1,4 % Na₂SO₃, die die wäßrige Haftschichtlösung aus Beispiel 1 zum Stabilisieren des Restmonomeren Crotonsäure enthält, werden der Haftschichtlösung weitere anorganische Salze zugesetzt:

| Beispiel | Zusatz | Menge (Gt) |
|---|---|---|
| 3a | NaCl | 2 |
| 3b | NaCl | 3 |
| 3c | Na₂SO₄ | 3 |
| 3d | KCl | 3 |

Die Beschichtung und Weiterverarbeitung erfolgt wie in Beispiel 1. Die Salzzusätze werden jeweils in einer Teilmenge des Wassers vorgelöst. Die Versuche beschränken sich auf die Farbe Magenta, da hierbei die Reduktion des Hintergrundschleiers den Vorteil der Erfindung besonders deutlich erkennen läßt. Die Tabelle I zeigt die Werte im einzelnen.

### Beispiel 4

Der Haftschichtlösung aus Beispiel 1 werden 2 Gt Ammoniumcrotonat zugesetzt. Die dehäsive Wirkung ist wesentlich geringer als in den vorangegangenen Beispielen für Zusätze anorganischer Salze. Trotzdem wird noch eine Reduktion des Hintergrundschleiers um 50 % erzielt.

### Beispiel 5

Der Haftschichtlösung von Beispiel 1 werden unterschiedliche Mengen Stearamidopropyl-dimethyl-(β-hydroxyethyl)ammoniumnitrat (SPDM) zugesetzt. Die Farbschichtrezepturen entsprechen dem Beispiel 1. Das SPDM wird vor der Zugabe zur Haftschichtlösung in der gleichen Menge Isopropanol gelöst und mit einer Teilmenge des in der Haftschichtlösung verwendeten Wassers versetzt. Die Zugabe der erhaltenen Lösung zur Haftschichtlösung muß langsam erfolgen, da sonst das gelöste Vinylacetat/Crotonsäure-Copolymere aufgrund des pH-Wertes des SPDM (4 - 6) ausfällt.

| Beispiel | Zusatz SPDM |
|---|---|
| 5a | 1,5 Gt |
| 5b | 2,0 Gt |
| 5c | 2,5 Gt |

Die Beschichtung und Weiterverarbeitung erfolgt wie im Beispiel 1. Abziehkraft und Belichtungszeiten verringern sich kontinuierlich mit steigendender Salzkonzentration. Der Oberflächenglanz steigt, der Einfluß auf den Hintergrundschleier wird, besonders im Beispiel 5c, deutlich reduziert. Der Tonwertumfang beträgt in allen Fällen 2 - 98 %. Die Oberflächenklebrigkeit ist geringer, was eine verbesserte Positionierbarkeit der Folien im Register bewirkt und eine Verkleben der Folien vor dem Laminieren, das zu Bildausrissen führt, verhindert. Der Punktzuwachs wird gesenkt (1 - 2 % im 60-er Raster bei 40 % Flächendeckung), damit wird das Mehrfarbenbild einem Druckbild ähnlicher.

### Beispiel 6

Die Wirkungsweise von kationischen Tensiden wird an zwei weiteren Beispielen gezeigt:

| Beispiel | Zusatz |
|---|---|
| 6a | 0,75 Gt Distearyldimethylammoniumchlorid (Präpagen ^{(R)}WK) |
| 6b | 5,0 Gt Trioctylmethylammoniumchlorid |

In beiden Fällen muß die Einarbeitung in die Haftschichtlösung langsam und unter Rühren erfolgen. Die Weiterverarbeitung kann erst nach vollständiger Auflösung der Zusätze in der beschriebenen Weise erfolgen. In beiden Fällen ist eine Reduktion der Belichtungszeit und des Hintergrundschleiers bei Magenta zu beobachten, die Wirkung des Trioctylmethylammoniumchlorids ist allerdings wesentlich schwächer als die des Präpagen WK. die Einzelwerte zeigt die Tabelle I.

### Vergleichsbeispiel (V)

Wie in Beispiel 1 beschrieben, wird eine Magenta-Farbprüffolie hergestellt, jedoch wird bei der Herstellung der Haftschicht gemäß Beispiel 1 kein Natriumsulfit zugesetzt. Die Menge an Polyvinylmethylether bleibt unverändert. Wenn die Beschichtungslösung innerhalb weniger Tage verarbeitet wird, ändert sich ihr Aussehen nicht.
Der Vergleich zeigt, daß eine wesentlich höhere Belichtungszeit und mehr als die doppelte Abziehkraft gegenüber der entsprechenden Farbfolie von Beispiel 1 erforderlich ist. Glanz und Tonwertumfang sind ebenfalls deutlich schlechter. Die Belichtungszeit ist wieder auf die in Beispiel 1 angegebene Zeit für die gleiche Farbe bezogen, die mit 100 bewertet wird.

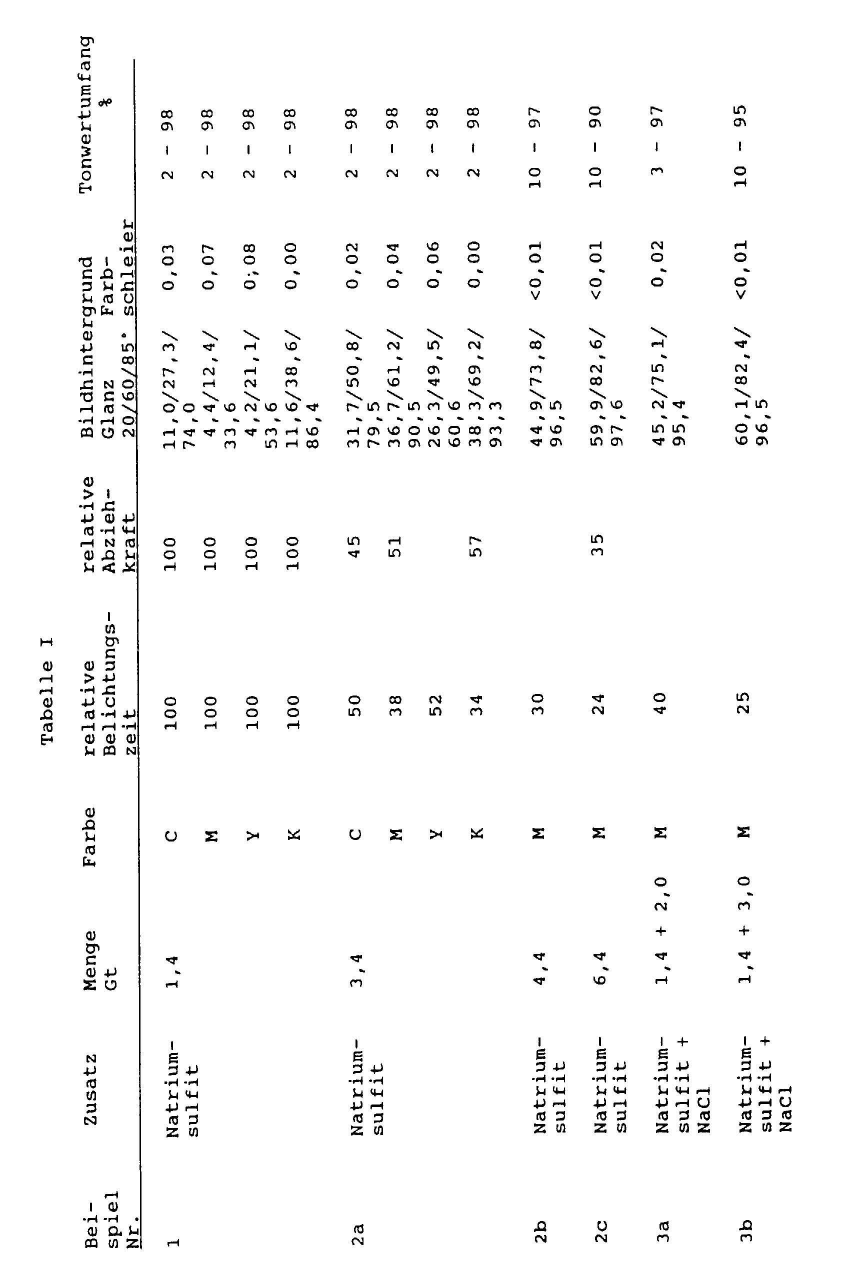

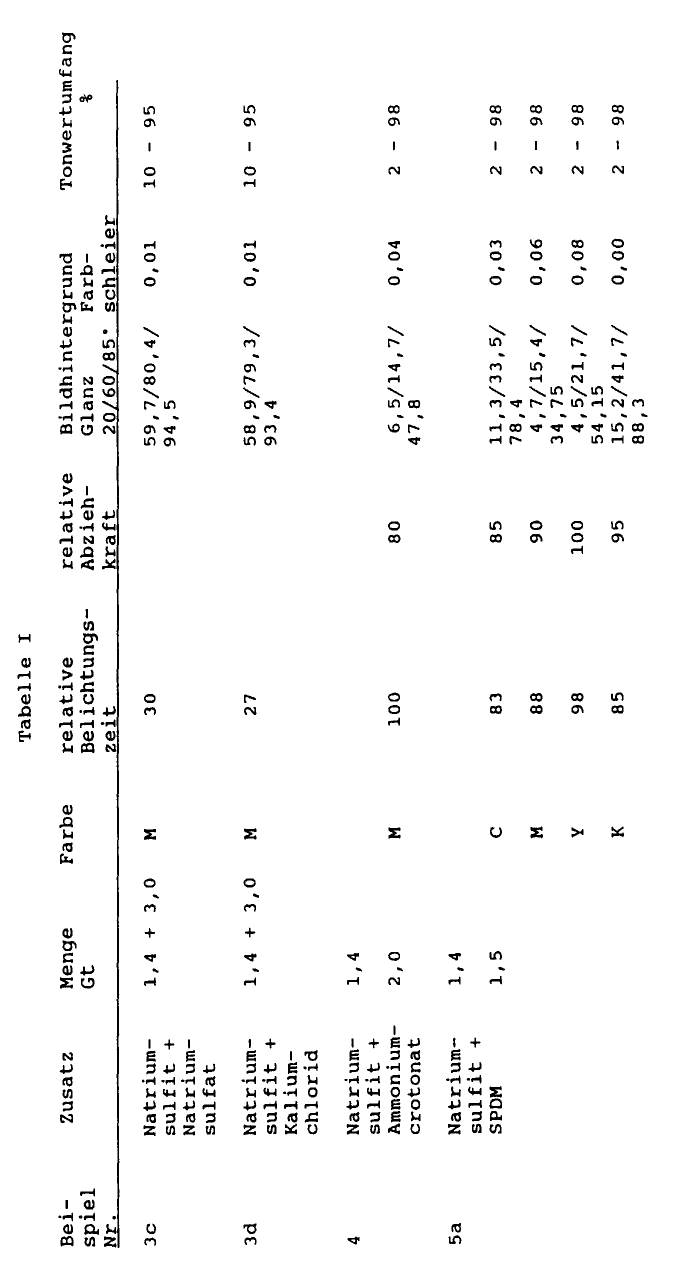

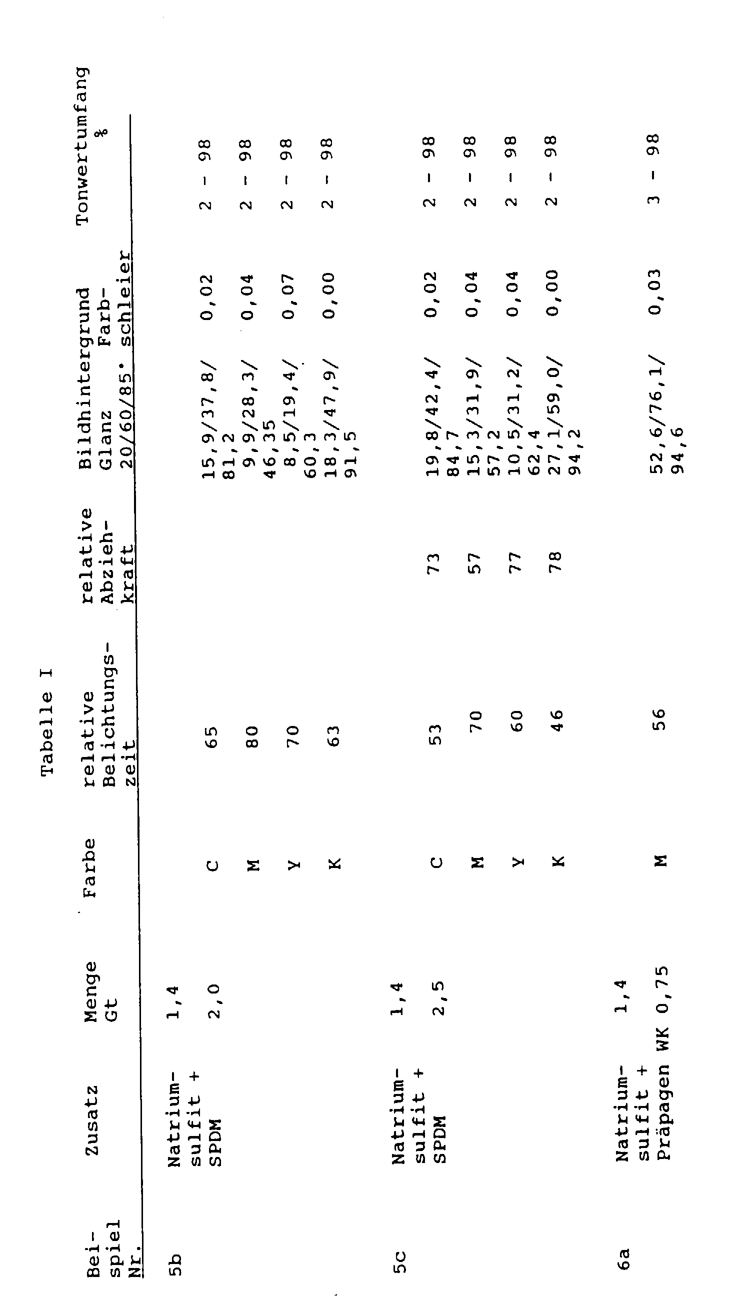

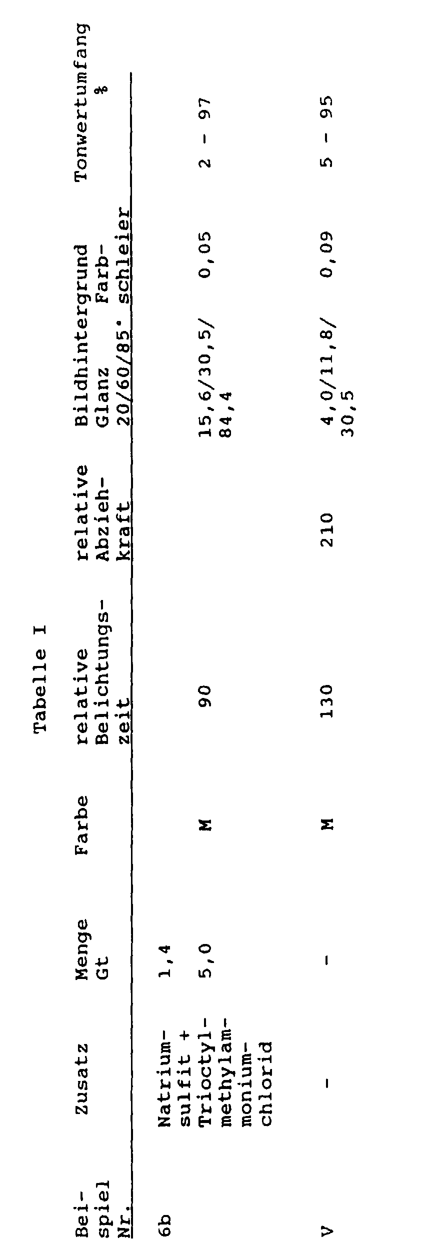

### Beispiel 7

Anstelle des 2-Diphenyl-4-yl-4,6-bis-trichlormethyl-striazins aus Beispiel 1 wird als Photoinitiator 2,3-Bis(4-methoxyphenyl)chinoxalin verwendet. Die Farbschichten haben folgende Zusammensetzung in Gewichtsteilen:

| | Cyan | Magenta | Gelb | Schwarz |
|---|---|---|---|---|
| Dipentaerythritpentaacrylat | 39,0 | 35,5 | 38,2 | 36,1 |
| 2,3-Bis-(4-methoxy-phenyl)chinoxalin | 9,8 | 7,8 | 9,5 | 9,6 |
| Polyvinylformal | 31,3 | 36,5 | 35,4 | 28,0 |
| Hostaperm^{(R)} Blau B2G | 19,0 | - | - | - |
| Permanentcarmin FBB | - | 18,5 | - | - |
| Permanentgelb GR | - | 0,7 | 16,4 | - |
| Ruß (Printex 25) | 0,4 | 0,5 | - | 24,8 |
| Silikonöl (Edaplan^{(R)} LA411) | 0,5 | 0,5 | 0,5 | 0,6 |
| Tetrahydrofuran | 1000,0 | 1000,0 | 1000,0 | 1000,0 |
| 1-Methoxy-2-propanol | 680,0 | 680,0 | 680,0 | 680,0 |
| gamma-Butyrolacton | 190,0 | 190,0 | 190,0 | 190,0 |

Die Herstellung der Farbschichten erfolgt in der in Beispiel 1 beschriebenen Weise.

Die Haftschichtlösung kann außer den in Beispiel 1 beschriebenen Bestandteilen inerte Partikel, z.B. SiO₂, zur Verbesserung der Gleiteigenschaften und zur zusätzlichen Senkung der Oberflächenklebrigkeit enthalten. Die Haftschichtlösung setzt sich dann wie folgt zusammen:

| **Bestandteil** | **Gt** |
|---|---|
| Vinylacetat/Crotonsäure-Copolymeres 95 : 5 | 96,6 |
| Polyvinylmethylether | 1,9 |
| Natriumsulfit | 1,4 |
| Wasser | 520,0 |
| Ethanol | 43,0 |
| Ammoniakwasser, 25 %-ig | 8,5 |
| pyrogene Kieselsäure (mittlere Teilchengröße 3 µm) | 0,1 |

Die Kieselsäure wird mit einer Dissolverscheibe in einen Teil des Binde- und Lösemittels eingearbeitet. Das Auftragen der Haftschicht und die Weiterverarbeitung der Folien folgt der Beschreibung von Beispiel 1.
Die Belichtungszeiten sind wegen des Initiatoraustausches für alle vier Farben im Vergleich zu Beispiel 1 etwa doppelt so lang. Der Hintergrundschleier ist bei der Farbe Gelb wegen der Diffusion des schwach gelb gefärbten Chinoxalins in die Haftschicht noch stärker als im Beispiel 1.

Auch hier kann durch den Zusatz einer größeren Salzmenge noch eine wesentliche Verbesserung erzielt werden, wie das Beispiel 8 zeigt.
Die Lösung wird auf die trockenen Farbschichten aufgetragen. Nach dem Trocknen beträgt das Schichtgewicht der Haftschicht 6,5 g/m².

### Beispiel 8

In der Haftschichtlösung aus Beispiel 7 wird der Na₂SO₃-Gehalt auf eine Gesamtmenge von 3,4 Gew.-%, bezogen auf die nichtflüchtigen Bestandteile der Haftschichtlösung, erhöht. Diese Haftschichtlösung wird auf die photopolymerisierbaren Farbschichten aus Beispiel 7 aufgetragen und getrocknet.
Die Abziehkräfte werden im Vergleich zu Beispiel 7 um 50 - 70 %, die Belichtungszeiten um 40 - 60 % reduziert. Ebenso wie in Beispiel 2 wird der Hintergrundschleier auch hier bei Magenta und Gelb deutlich verbessert. Da bereits der Zusatz von SiO₂-Partikeln die Klebrigkeit der Oberfläche beseitigt, hat der Zusatz von Natriumsulfit keine Auswirkung mehr auf die Oberflächenklebrigkeit.

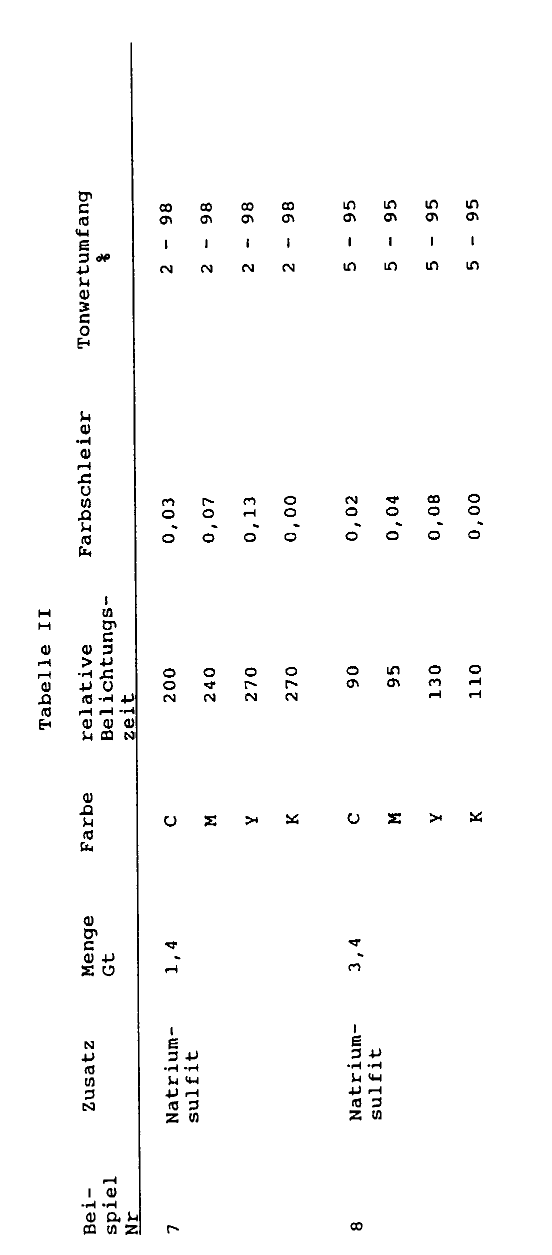

## Patentansprüche

1. Lichtempfindliches Material für die Herstellung von Farbprüffolien für den Mehrfarbendruck mit
A) einer transparenten flexiblen Trägerfolie aus Kunststoff,
B) einer photopolymerisierbaren Schicht, die
B1) ein polymeres Bindemittel,
B2) eine radikalisch polymerisierbare Verbindung,
B3) eine Verbindung, die unter Einwirkung von aktinischem Licht die Polymerisation von (B2) einzuleiten vermag, und
B4) einen Farbstoff oder ein Farbpigment in einer Grundfarbe des Mehrfarbendrucks enthält, und
C) einer thermoplastischen Haftschicht auf der lichtempfindlichen Schicht,
dadurch gekennzeichnet, daß die Haftschicht C mindestens 1,5 Gew.-% eines wasserlöslichen farblosen niedermolekularen Salzes enthält, dessen wäßrige Lösung nicht stark sauer reagiert.

2. Lichtempfindliches Material nach Anspruch 1, dadurch gekennzeichnet, daß das Salz ein anorganisches Kation aufweist.

3. Lichtempfindliches Material nach Anspruch 2, dadurch gekennzeichnet, daß das Kation ein Alkalimetall-, Erdalkalimetall- oder das Ammoniumkation ist.

4. Lichtempfindliches Material nach Anspruch 1, dadurch gekennzeichnet, daß das Salz ein quaternäres Ammoniumsalz ist.

5. Lichtempfindliches Material nach Anspruch 4, dadurch gekennzeichnet, daß das Salz ein kationisches oberflächenaktives Mittel ist.

6. Lichtempfindliches Material nach Anspruch 1, dadurch gekennzeichnet, daß das Salz das Anion einer Mineralsäure oder einer organischen niedermolekularen Säure enthält.

7. Lichtempfindliches Material nach Anspruch 1, dadurch gekennzeichnet, daß die Haftschicht C 2 bis 5 Gew.-% des wasserlöslichen Salzes enthält.

8. Verfahren zur Herstellung eines Mehrfarbenbilds, dadurch gekennzeichnet, daß man ein lichtempfindliches Material der in Anspruch 1 angegebenen Zusammensetzung mit der Haftschicht unter Druck auf ein Bildempfangsmaterial laminiert, durch die Trägerfolie hindurch mit einem Farbauszug bildmäßig belichtet, die Trägerfolie zusammen mit den Nichtbildstellen von dem Bildempfangsmaterial abzieht und die Schritte Laminieren, Belichten und Abziehen mit mindestens einem weiteren Farbauszug wiederholt, wobei das Belichten im Register mit dem ersten auf dem Bildempfangsmaterial erzeugten Teilfarbenbild erfolgt.

9. Verfahren zur Herstellung eines Mehrfarbenbilds, dadurch gekennzeichnet, daß man eine Haftschicht der in Anspruch 1 angegebenen Zusammensetzung auf ein Bildempfangsmaterial laminiert, ein lichtempfindliches Material aus einer transparenten flexiblen Trägerfolie und einer photopolymerisierbaren Schicht der in Anspruch 1 angegebenen Zusammensetzung mit der photopolymerisiserbaren Schicht auf die Haftschicht laminiert, die photopolymerisierbare Schicht durch die Trägerfolie hindurch mit einem Farbauszug bildmäßig belichtet, die Trägerfolie zusammen mit den Nichtbildstellen von dem Bildempfangsmaterial abzieht und die Schritte
- Laminieren einer Haftschicht
- Laminieren eines lichtempfindlichen Materials
- Belichten und
- Abziehen
mit mindestens einem weiteren Farbauszug wiederholt, wobei das Belichten im Register mit dem ersten auf dem Bildempfangsmaterial erzeugten Teilfarbenbild erfolgt.

10. Verwendung eines wasserlöslichen farblosen niedermolekularen Salzes als Zusatz zu einer thermoplastischen Haftschicht in Verbindung mit einer photopolymerisierbaren Schicht der in Anspruch 1 angegebenen Zusammensetzung zur Verminderung der Haftkraft zwischen thermoplastischer Haftschicht und photopolymerisierbarer Schicht.

## Claims

1. A light-sensitive material for the production of colour test films for multi-colour printing, having
A) a transparent, flexible backing film made of plastic,
B) a photopolymerisable layer, which contains
B1) a polymeric binder,
B2) a compound which is polymerisable by a radical mechanism,
B3) a compound which is capable of initiating the polymerisation of (B2) under the effect of actinic light, and
B4) a dye or a colouring pigment in a primary colour of the multi-colour print, and
C) a thermoplastic adhesive layer on the light-sensitive layer,
characterised in that the adhesive layer C contains at least 1.5 % by weight of a water-soluble, colourless salt of low molecular weight, the aqueous solution of which does not have a strongly acidic reaction.

2. A light-sensitive material according to claim 1, characterised in that the salt comprises an inorganic cation.

3. A light-sensitive material according to claim 2, characterised in that the cation is an alkali metal cation, an alkaline earth metal cation or the ammonium cation.

4. A light-sensitive material according to claim 1, characterised in that the salt is a quaternary ammonium salt.

5. A light-sensitive material according to claim 4, characterised in that the salt is a cationic surface-active agent.

6. A light-sensitive material according to claim 1, characterised in that the salt contains the anion of a mineral acid or of an organic acid of low molecular weight.

7. A light-sensitive material according to claim 1, characterised in that the adhesive layer C contains 2 to 5 % by weight of the water-soluble salt.

8. A method of producing a multi-colour image, characterised in that a light-sensitive material of the composition defined in claim 1 is laminated under pressure with its adhesive layer on to an image-receiving material, is exposed to form an image through the backing layer with a colour separation, the backing film, together with the non-image locations, is stripped from the image-receiving material, and the steps of laminating, exposure and stripping are repeated with at least one further colour separation, wherein exposure is effected in register with the first partial colour image produced on the image-receiving material.

9. A method of producing a multi-colour image, characterised in that an adhesive layer of the composition defined in claim 1 is laminated on to an image-receiving material, a light-sensitive material comprising a transparent flexible backing film and a photopolymerisable layer of the composition defined in claim 1 is laminated with its photopolymerisable layer on to the adhesive layer, the photopolymerisable layer is exposed to form an image through the backing film with a colour separation, the backing film, together with the non-image locations, is stripped from the image-receiving material, and the steps comprising
- laminating an adhesive layer
- laminating a light-sensitive material
- exposure, and
- stripping
are repeated with at least one further colour separation, wherein exposure is effected in register with the first partial colour image produced on the image-receiving material.

10. The use of a water-soluble, colourless salt of low molecular weight as an additive to a thermoplastic adhesive layer in combination with a photopolymerisable layer of the composition defined in claim 1 for reducing the force of adhesion between the thermoplastic adhesive layer and the photopolymerisable layer.

## Revendications

1. Matériau photosensible pour la fabrication d'épreuves couleurs pour l'impression polychrome comprenant
A) une feuille porteuse transparente et souple en matière plastique,
B) une couche photopolymérisable, qui comporte
B1) un liant polymère,
B2) un composé polymérisable par voie radicalaire,
B3) un composé, qui peut amorcer la polymérisation de (B2) sous l'action de lumière actinique, et
B4) un colorant ou un pigment colorant dans une couleur primaire de l'impression poly-chrome, et
C) une couche adhésive thermoplastique sur la couche photosensible
caractérisé en ce que la couche adhésive C renferme au moins 1,5 % en poids d'un sel incolore, de faible poids moléculaire, soluble dans l'eau, dont la solution aqueuse n'est pas à réaction acide forte.

2. Matériau photosensible selon la revendication 1, caractérisé en ce que le sel présente un cation inorganique

3. Matériau photosensible selon la revendication 2, caractérisé en ce que le cation est un cation de métal alcalin ou alcalino-terreux ou le cation d'ammonium.

4. Matériau photosensible selon la revendication 1, caractérisé en ce que le sel est un sel quaternaire d'ammonium.

5. Matériau photosensible selon la revendication 4, caractérisé en ce que le sel est un tensioactif cationique.

6. Matériau photosensible selon la revendication 1, caractérisé en ce que le sel est l'anion d'un acide minéral ou d'un acide organique de bas poids moléculaire.

7. Matériau photosensible selon la revendication 1, caractérisé en ce que la couche adhésive C renferme 2 à 5 % en poids du sel soluble dans l'eau.

8. Procédé de fabrication d'une image polychrome, caractérisé en ce que l'on lamine un matériau photosensible de la composition spécifiée à la revendication 1 avec la couche adhésive, sous pression, sur un matériau récepteur d'image, on l'expose au travers de la feuille porteuse en forme d'image avec une sélection des couleurs, on sépare la feuille porteuse conjointement avec les zones non formatrices d'images du matériau récepteur de couleurs, et que l'on répète les étapes de laminage, d'exposition et de séparation avec au moins une autre sélection des couleurs, l'exposition se déroulant en repérage avec la première image de couleur partielle produite sur le matériau récepteur d'image.

9. Procédé de fabrication d'une image polychrome, caractérisé en ce que l'on lamine sur un matériau récepteur d'image une couche adhésive de la composition spécifiée à la revendication 1, on lamine sur la couche adhésive un matériau photosensible constitué d'une feuille porteuse transparente et souple et d'une couche photopolymérisable de la composition spécifiée à la revendication 1 avec la couche photopolymérisable, on expose la couche photopolymérisable au travers de la feuille porteuse en forme d'image avec une sélection des couleurs, on sépare la feuille porteuse conjointement avec les zones non formatrices d'images du matériau récepteur d'images et on répète les étapes de
- laminage d'une couche adhésive
- laminage d'un matériau photosensible
- exposition et
- séparation
avec au moins une autre sélection des couleurs, l'exposition se déroulant en repérage avec la première image de couleur partielle produite sur le matériau récepteur d'image.

10. Utilisation d'un sel de bas poids moléculaire, incolore et soluble dans l'eau, comme adjonction à une couche adhésive thermoplastique en association avec une couche photopolymérisable de la composition spécifiée à la revendication 1, pour diminuer la force d'adhérence entre la couche adhésive thermoplastique et la couche photopolymérisable.
